# EUROPEAN PATENT APPLICATION

(11) **EP 4 472 051 A1**
(43) Date of publication of application: **04.12.2024**
(21) Application number: 23747324.4
(22) Date of filing: 26.01.2023
(51) Int. Cl.: H02M 3/00, H02M 3/335, H02M 5/10, H01F 27/02, H01F 27/40

(54) **SEMICONDUCTOR TRANSFORMER AND MODULAR HIGH-VOLTAGE POWER DEVICE**

(30) Priority: 28.01.2022 KR 20220012976
(71) Applicant: LS Electric Co., Ltd., Anyang-si, Gyeonggi-do 14119 (KR)
(72) Inventor: LIM, Jeong Woo, Anyang-si, Gyeonggi-do 14118 (KR); SIM, Jung Wook, Anyang-si, Gyeonggi-do 14118 (KR)
(74) Representative: K&L Gates LLP
(86) International application number: PCT/KR2023/001158
(87) International publication number: WO 2023/146283

(57) **Abstract**

A semiconductor transformer according to one embodiment of the present invention comprises a plurality of semiconductor transformer modules for transforming power, wherein each of the semiconductor transformer modules comprises: a high-voltage unit for transforming low-frequency AC power into high-frequency AC power; a transformation unit for transforming the transformed high-frequency AC power to high-frequency low-voltage AC power; and a low-voltage unit for transforming the transformed high-frequency low-voltage AC power to low-voltage DC power, the high-voltage unit is provided inside a housing made of a conductive material, and the housing has a ground line connected to one from among circuit lines of the high-voltage unit.

## Description

### [Technical Field]

The present invention relates to a technology related to a semiconductor transformer and a modular high-voltage power device.

### [Background Art]

Power transformers serve to divide power through a voltage variable function at branch points for power transmission, power distribution, and electrical distribution in systems. However, since existing power transformers use a method of directly varying a low-frequency AC voltage, elements are large, and thus volume and mass thereof are large, and also input and output control is impossible.

In order to solve these problems of existing power transformers, semiconductor transformers have been proposed. In other words, semiconductor transformers use a method in which a configuration of a power conversion device has been changed in a more efficient manner as compared to existing power transformers. Such semiconductor transformers can be applied to various technologies such as new renewable energy, DC distribution, and electric vehicle charging through DC links.

In particular, semiconductor transformers can implement various functions of converting AC/DC power and controlling power factors and harmonic waves as well as varying voltages. By adopting high-frequency transformers, the volume and weight can be considerably reduced as compared to existing power transformers. In addition, high-voltage input voltages may be directly applied to semiconductor transformers may directly apply, thereby reducing the number of operations of conversion processes to increase efficiency.

Such a semiconductor transformer includes a plurality of modules for conversion, and each module includes a high-voltage portion that processes high-voltage power and a low-voltage portion that processes low-voltage power. In particular, the high-voltage portion of each module includes a housing made of a conductive material, and the housings are insulated from each other. In this case, a degree (strength) of insulation between two housings may vary according to a voltage difference according to the arrangement and ground positions of the housings.

In the case of conventional semiconductor transformers, housings are disposed such that a corresponding voltage difference is large. Accordingly, the corresponding degree of insulation should be increased, resulting in increases in the total cost and volume of the semiconductor transformer.

However, the above-described content merely provides background information related to the present invention and does not correspond to previously disclosed technology.

### [Disclosure]

### [Technical Problem]

In order to solve the above problems, the present invention is directed to providing a semiconductor transformer and a modular high-voltage power device which are implemented to reduce a potential difference between housings of high-voltage portions in a plurality of semiconductor transformer modules, thereby reducing a degree of insulation between the housings.

However, objects to be solved by the present invention are not limited to the objects described above, and other objects that are not described will be clearly understood by a person skilled in the art from the description below.

### [Technical Solution]

In order to solve the above problems, a semiconductor transformer according to one embodiment of the present invention includes a plurality of semiconductor transformer modules configured to convert power, wherein each of the semiconductor transformer modules includes a high-voltage portion configured to convert low-frequency AC power into high-frequency AC power, a transformation portion configured to transform the converted high-frequency AC power into high-frequency and low-voltage AC power, and a low-voltage portion configured to convert the transformed high-frequency and low-voltage AC power into low-voltage DC power.

The high-voltage portion may be provided in a housing made of a conductive material, and a ground line of the housing may be connected to one of circuit lines of the high-voltage portion.

The high-voltage portions of the plurality of semiconductor transformer modules may be connected in series to each other in terms of power.

The housings of the plurality of semiconductor transformer modules may be disposed in a stack structure or a planar array structure according to a series order, and insulating structures may be implemented between the housings.

The ground line of each housing may be connected to a circuit line to which a potential having the same potential difference with respect to the same reference point in each high-voltage portion is applied.

The insulating structures between the housings may have an insulation distance in the same range.

In at least one of a plurality of housing pairs consisting of two adjacent housings, among two ground lines in a corresponding housing pair, a first ground line may be connected to a circuit line to which a potential having a high potential difference with respect to the same reference point in each high-voltage portion is applied as compared to the other second ground line.

The at least one housing pair may have a shorter insulation distance than at least one of the other housing pairs.

The at least one housing pair may have a longer insulation distance than at least one of the other housing pairs.

In at least one housing pair among a plurality of housing pairs consisting of two adjacent housings, ground lines may be connected to a circuit line to which a potential having the same potential difference with respect to the same reference point in each high-voltage portion is applied, and in at least another housing pair among the plurality of housing pairs, among two ground lines in a corresponding housing pair, a first ground line may be connected to a circuit line to which a potential having a high potential difference with respect to the same reference point in each high-voltage portion is applied as compared to the other second ground line.

A modular high-voltage power device according to one embodiment of the present invention includes a plurality of modules which are connected in series and to which voltages of input power are distributed, wherein each of the modules includes a potentiodynamic device configured to electrically connect a specific part of the module, and a module housing made of a conductive material, wherein a ground line of the module housing is connected to one of circuit lines of the potentiodynamic device.

The potentiodynamic devices may be connected in series with each other in terms of power.

The housings of the plurality of semiconductor transformer modules may be disposed in a stack structure or a planar array structure according to a series order, and insulating structures may be implemented between the housings.

The ground line of each housing may be connected to a circuit line to which a potential having the same potential difference with respect to the same reference point in each potentiodynamic device is applied.

The insulating structures between the housings may have an insulation distance in the same range.

In at least one of a plurality of housing pairs consisting of two adjacent housings, among two ground lines in a corresponding housing pair, a first ground line may be connected to a circuit line to which a potential having a high potential difference with respect to the same reference point in each high-voltage portion is applied as compared to the other second ground line.

The at least one housing pair may have a shorter insulation distance than at least one of the other housing pairs.

The at least one housing pair may have a longer insulation distance than at least one of the other housing pairs.

In at least one housing pair among a plurality of housing pairs consisting of two adjacent housings, ground lines may be connected to a circuit line to which a potential having the same potential difference with respect to the same reference point in each high-voltage portion is applied, and in at least another housing pair among the plurality of housing pairs, among two ground lines in a corresponding housing pair, a first ground line may be connected to a circuit line to which a potential having a high potential difference with respect to the same reference point in each high-voltage portion is applied as compared to the other second ground line.

### [Advantageous Effects]

The present invention configured as described above can be implemented to reduce a potential difference between housings of high-voltage portions in a modular high-voltage power device including a plurality of semiconductor transformer modules, and thus a degree of insulation between the housings can be reduced, thereby obtaining an advantage capable of reducing manufacturing costs and volume.

The effects obtainable in the present invention are not limited to the effects described above, and other effects that are not described will be clearly understood by a person skilled in the art from the description below.

### [Description of Drawings]

FIG. 1 is a view illustrating a configuration of a semiconductor transformer (1) according to one embodiment of the present invention.
FIG. 2 is a view illustrating a case in which a position of a housing including in a transformer in FIG. 1 is changed.
FIG. 3 illustrates a series connection structure of a plurality of semiconductor transformer modules (10) in the semiconductor transformer (1) according to one embodiment of the present invention.
FIG. 4 illustrates an example of a circuit diagram (for example, a, topology) of each semiconductor transformer module (10_1, 10_2, ..., or 10_n).
FIG. 5 illustrates an example of a potential applied to a semiconductor transformer according to a first comparative example.
FIG. 6 illustrates an example of a potential applied to a semiconductor transformer according to a second comparative example.
FIG. 7 illustrates an example of a potential applied to the semiconductor transformer (1) according to one embodiment of the present invention.

### [Modes of the Invention]

The above-described objects and means of the present invention and the effects associated therewith will become more apparent through the following detailed description in conjunction with the accompanying drawings. Accordingly, those skilled in the art to which the present invention pertains can readily implement the technical spirit of the present invention. In addition, when it is determined that detailed descriptions of related well-known functions unnecessarily obscure the gist of the present invention during the description of the present invention, the detailed descriptions will be omitted.

Terms used herein are for the purpose of describing embodiments only and are not intended to limit the present invention. In the present specification, the singular forms "a" and "an" are intended to include the plural forms as well in some cases, unless the context clearly indicates otherwise. In the present specification, terms such as "comprise," "comprising," "include," "including," "have," and/or "having," do not preclude the presence or addition of one or more other components other than the components described.

In the present specification, terms such as "or," "at least one," and the like may represent one of the words listed together or may represent a combination of two or more. For example, "A or B" and "at least one of A and B" may include only one of A or B, and may include both A and B.

In the present specification, descriptions following "for example" may not exactly match the information presented, such as cited characteristics, variables, or values, and embodiments of the present invention according to various embodiments of the present invention should not be limited by effects such as modifications including limits of tolerances, measurement errors, and measurement accuracy, and other commonly known factors.

In the present specification, when it is described that one component is "connected" or "joined" to another component, it should be understood that the one component may be directly connected or joined to another component but an additional component may be present therebetween. However, when one component is described as being "directly connected," or "directly coupled" to another component, it should be understood that the additional component may be absent between the one component and another component.

In the present specification, when one component is described as being "on" or "in contact with" another component, it should be understood that the one component may be directly in contact with or connected to another component, but additional component may be present between the one component and another component. However, when one component is described as being "directly on" or "in direct contact with" another component, it should be understood that there is no additional component between the one component and another component. Other expressions describing the relationship between components, such as "between^{∼}," "directly between ^{∼}," and the like should be interpreted in the same way.

In the present specification, terms such as "first" and "second" may be used to describe various components, but the components should not be limited by the above terms. In addition, the above terms should not be interpreted as limiting the order of each component but may be used for the purpose of distinguishing one component from another. For example, a "first component" could be termed a "second component," and similarly, a "second component" could also be termed a "first component."

Unless defined otherwise, all terms used herein may be used in a sense commonly understood by those skilled in the art to which the present invention pertains. Further, terms defined in a commonly used dictionary are not to be interpreted ideally or excessively unless otherwise defined.

Hereinafter, exemplary embodiments according to the present invention will be described in detail with reference to the accompanying drawings.

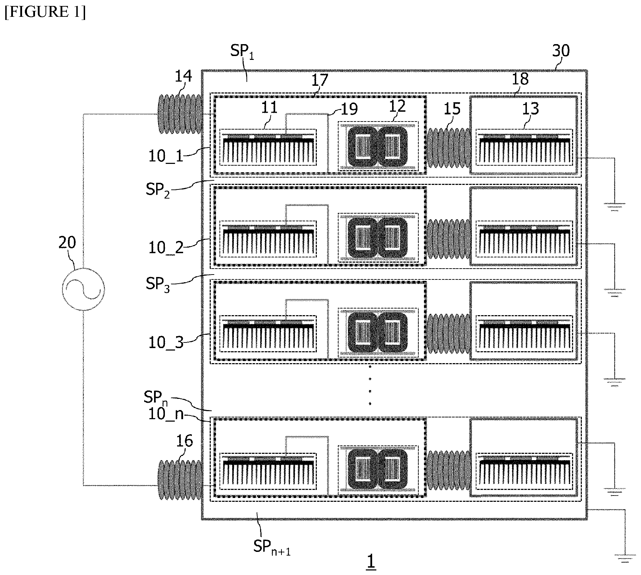

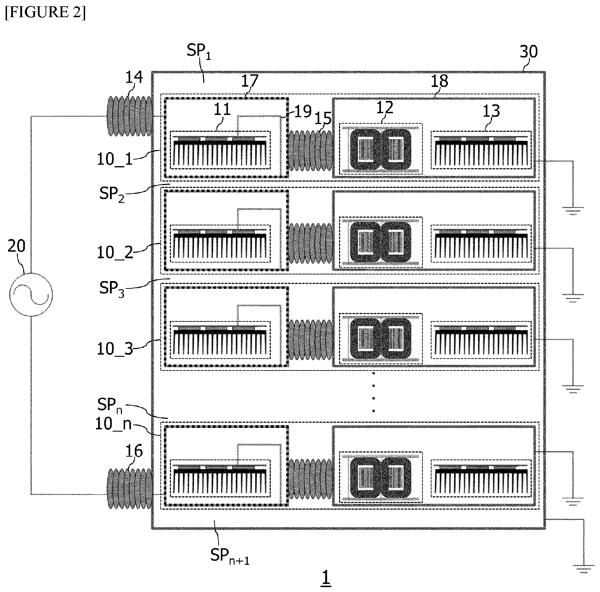

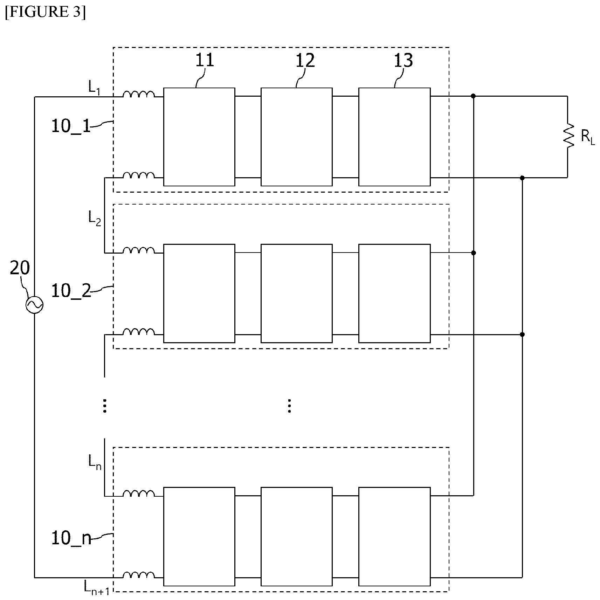

FIG. 1 is a view illustrating a configuration of a semiconductor transformer 1 according to one embodiment of the present invention. FIG. 2 is a view illustrating a case in which a position of a housing including in a transformer in FIG. 1 is changed. In addition, FIG. 3 illustrates a series connection structure of a plurality of semiconductor transformer modules 10 in the semiconductor transformer 1 according to one embodiment of the present invention.

The semiconductor transformer 1 according to one embodiment of the present invention is a solid state transformer (SST) used for power. As an example, the semiconductor transformer 1 used for power may serve to divide power through a voltage variable function at branch points for power transmission, power distribution, and electrical distribution in a system. However, the semiconductor transformer 1 may have a reduced size and high efficiency as compared to existing power transformers which are heavy and bulky.

In addition, the semiconductor transformer 1 according to one embodiment of the present invention may be applied to a power distribution system. Such SSTs may be classified into a non-modular SST, a semi-modular SST, and a modular SST. That is, the semiconductor transformer 1 may be a modular SST in which semiconductor transformer modules 10_1, 10_2, ..., and 10_n are connected in series.

As shown in FIGS. 1 and 2, the semiconductor transformer 1 includes the plurality of semiconductor transformer modules 10. That is, the semiconductor transformer 1 may be implemented as a series system, and as shown in FIG. 3, the semiconductor transformer may include the semiconductor transformer modules 10_1, 10_2, ..., and 10_n which are a plurality of sub-systems connected in series with each other with respect to a power source 20, where n is a natural number of 2 or more. In this case, the semiconductor transformer 1 may be disposed inside a first housing 30 and protected by the first housing 30.

Each transformer module 10 includes a high-voltage portion 11 (also referred to as a high-voltage unit 11), a transformation portion 12 (also referred to as a transformation unit 12), and a low-voltage portion 13 (also referred to as a low-voltage unit 13) which are components for converting power of the power source 20 and includes bushings 14, 15, and 16 and housings 17 and 18 which are components for connecting and protecting the high-voltage portion 11, the transformation portion 12, and the low-voltage portion 13. The housing 30 may preferably include a conductive material and may be connected to an external ground.

The high-voltage portion 11 is a component for processing high-voltage power and converts low-frequency AC power output from the power source 20 into high-frequency AC power. For example, the high-voltage portion 11 may convert low-frequency AC power into DC power and convert the converted DC power into high-frequency AC power. The transformation portion 12 is a component for transforming power and transforms the high-frequency AC power converted by the high-voltage portion 11 into high-frequency and low-voltage AC power. The low-voltage portion 13 is a component for processing low-voltage power and converts the high-frequency and low-voltage AC transformed by the transformation portion 12 into low-voltage DC power. Of course, the low-voltage portion 13 may further include a component (that is, a DC-AC converter) that converts the converted low-voltage DC power into AC power. In this case, a high frequency is a frequency that is higher than the commercial frequency (60 Hz). As an example, a low frequency may be 60 Hz or the like, and a high frequency may be 10 kHz or the like, but the present invention is not limited thereto.

In each semiconductor transformer module 10, the high-voltage portion 11, the transformation portion 12, and the low-voltage portion 13 may be disposed inside second and third housings 17 and 18 and protected by the second and third housings 17 and 18. As an example, as shown in FIG. 1, the high-voltage portion 11 and the transformation portion 12 may be included in the second housing 17, and the low-voltage portion 13 may be included in the third housing 18. Alternatively, as shown in FIG. 2, the high-voltage portion 11 may be included in the second housing 17, and the transformation portion 12 and the low-voltage portion 13 may be included in the third housing 18. The second and third housings 17 and 18 may preferably include a conductive material and may be connected to an external ground.

In addition, in each semiconductor transformer module 10, as shown in FIGS. 1 and 2, a line between the second housing 17 and the third housing 18 may be connected through the bushing 15. That is, as shown in FIG. 1, the bushing 15 may be provided on a line between the transformation portion 12 and the low-voltage portion 13. Alternatively, as shown in FIG. 2, the bushing 15 may be provided on a line between the high-voltage portion 11 and the low-voltage portion 13.

Hereinafter, the high-voltage portion 11, the low-voltage portion 13, the second housing 17, and the third housing 18 of a first semiconductor transformer module 10_1 will be referred to as a "first high-voltage portion," a "first low-voltage portion," a "2_1 housing," and a "3_1 housing," respectively, and the high-voltage portion 11, the low-voltage portion 13, the second housing 17, and the third housing 18 of a second semiconductor transformer module 10_2 will be referred to as a "second high-voltage portion," a "second low-voltage portion," a "2_2 housing," and a "3_2 housing," respectively. In this way, the high-voltage portion 11, the low-voltage portion 13, the second housing 17, and the third housing 18 of an (n-l)^{th} semiconductor transformer module 10_n-1 will be referred to as a "(n-1)^{th} high-voltage portion," a "(n-1)^{th} low-voltage portion," a "2_n-1 housing," and a "3_n-1 housing," respectively, and the high-voltage portion 11, the low-voltage portion 13, the second housing 17, and the third housing 18 of an n^{th} semiconductor transformer module 10_n will be referred to as an "n^{th} high-voltage portion," an "n^{th} low-voltage portion," a "2_n housing," and a "3_n housing," respectively.

Meanwhile, a space between the 2_1 housing and the first housing 30 is referred to as a "first space SP₁," and a space between the 2_n housing and the first housing 30 is referred to as an "(n+1)^{th} space SPₙ." In addition, a space between the 2_1 housing and the 2_2 housing is referred to as a "second space SP₂," a space between the 2_2 housing and a 2_3 housing is referred to as a "third space SP₃," and in this way, a space between the 2_n-1 housing and the 2_n housing is referred to as an "n^{th} space SPₙ."

Referring to FIG. 3, the series connection structure of the plurality of semiconductor transformer modules 10_1, 10_2, ..., and 10_n is as follows. That is, a first power line L₁ is provided between a first output terminal of the power source 20 and a first input terminal of the first semiconductor transformer module 10_1 (that is, a first input terminal of the first high-voltage portion). A second power line L₂ is provided between a second input terminal of the first semiconductor transformer module 10_1 (that is, a second input terminal of the first high-voltage portion) and a first input terminal of the second semiconductor transformer module 10_2 (that is, a first input terminal of the second high-voltage portion). An n^{th} power line Lₙ is provided between a second input terminal of the (n-1)^{th} semiconductor transformer module 10_n-1 (that is, a second input terminal of an (n-1)^{th} high-voltage portion) and a first input terminal of the n^{th} semiconductor transformer module 10_n (that is, a first input terminal (the n^{th} high-voltage portion). An (n+1)^{th} power line Lₙ₊₁ is formed between a second input terminal of the n^{th} semiconductor transformer module 10_n (that is, a second input terminal of the n^{th} high-voltage portion) and a second output terminal of the power source 20.

Accordingly, while power of the power source 20 is transmitted through the power lines L₁, L₂, ..., Lₙ, and Lₙ₊₁, voltage-distributed power is sequentially supplied to the semiconductor transformer modules 10_1, 10_2, ..., and 10_n connected in series. That is, a voltage of power of the power source 20 is distributed according to a series connection, and the distributed voltage is sequentially supplied to first to n^{th} high-voltage portions connected in series. However, in FIG. 3, although inductors are shown as being connected to the lines L₁, L₂, ..., Lₙ, and Lₙ₊₁, the present invention is not limited thereto. That is, active elements (such as inductors) or passive elements (such as resistors) may be additionally connected to the lines L₁, L₂, ..., Lₙ, and Lₙ₊₁.

As an example, when n is 10 and a power of 10 kV is supplied from the power source 20, the first to n^{th} high-voltage portions are implemented to have identical specifications , and thus the same power is distributed to each of the first to n^{th} high-voltage portions. Accordingly, a power of 1 kV may be equally distributed and supplied to each of the first to n^{th} high-voltage portions.

Meanwhile, a line connected to the power source 20 may be connected through the bushing 14. That is, the bushing 14 may be provided on the power line L₁, and the bushing 16 may be provided on the power line Lₙ₊₁.

In addition, first output terminals of the semiconductor transformer modules 10_1, 10_2, ..., and 10_n are connected to a first terminal of a load R_{L}, and second output terminals of the semiconductor transformer modules 10_1, 10_2, ..., and 10_n are connected to a second terminal of the load R_{L}.

That is, power of the power source 20 is distributed in series and provided to each semiconductor transformer module 10_1, 10_2, ..., or 10_n according to its load, each semiconductor transformer module 10_1, 10_2, ..., or 10_n performs a transforming function on the power distributed in series, and the transformed power is transmitted to the load R_{L}. In addition, a controller (not shown) for controlling a transforming function of the high-voltage portion 11 and the low-voltage portion 13 may be included in the semiconductor transformer 1.

Meanwhile, the load R_{L} shown in FIG. 3 may be a line such as a distribution line, a DC-AC converter, or various systems that perform specific functions using transformed DC power. As an example, the load R_{L} may be a system including an inverter or a programmable logic controller (PLC) that controls the driving of an electric motor and may be a system for various functions related to measurement, communication, input, output, calculation, and the like, but the present invention is not limited thereto.

In the semiconductor transformer 1, the second housings 17 for the high-voltage portions 11 are insulated from each other. That is, an insulating structure is implemented in each of second to n^{th} spaces SP₂ to SPₙ, and an insulating structure is additionally implemented in the first and (n+1)^{th} spaces SP₁ and SPₙ₊₁. In addition, the third housings 18 of the low-voltage portion 13 are also insulated from each other. Of course, in each semiconductor transformer module 10, the second housing 17 and the high-voltage portion 11 therein may be insulated from each other, and the third housing 18 and the low-voltage portion 13 therein may be insulated from each other.

As an example, the insulating structure may be a structure in which the space SP is filled with an insulating material. In the insulating structure, an increase in degree of insulation may be an increase in insulation distance, and a decrease in degree of insulation may be a decrease in insulation distance.

In this case, as a degree of insulation for a corresponding space increases, an insulation distance should also increase, and a degree of insulation between the second housings 17 of the high-voltage portions 11, which process relatively high-voltage power, should be higher than a degree of insulation between the third housings 18 of the low-voltage portions 13. Accordingly, the degree of insulation between the second housings 17 of the high-voltage portions 11 considerably affects the total price and volume of the semiconductor transformer 1.

That is, the degree of insulation (strength) between two second housings 17 may vary according to a potential difference between the corresponding second housings 17, and the potential difference may vary according to the arrangement and ground position of the corresponding second housings 17. In this case, as a corresponding potential difference becomes larger, a high degree of insulation should be implemented, and thus a price and a volume increase.

As an example, the n^{th} space SPₙ should have a degree of insulation proportional to a potential difference between the 2_n-1 housing and the 2_n housing. When the second housings 17 are designed such that a potential difference between two adj acent second housings 17 is large, there is a problem that a degree of insulation for each of the second to n^{th} spaces SP₂ to SPₙ increases, and thus the total cost and volume of the semiconductor transformer increase.

Accordingly, in the semiconductor transformer 1 according to one embodiment of the present invention, the above-described problem can be solved through a combination of an "arrangement structure" and a "ground connection structure" which will be described below.

First, with regard to the "arrangement structure," the semiconductor transformer modules 10 connected in series have a structure in which the semiconductor transformer modules 10 are sequentially disposed. In this case, "sequentially arranged structure" means that the first to n^{th} semiconductor transformer modules 10_1 to 10_n are sequentially disposed. That is, the second semiconductor transformer module 10_2 is disposed subsequent to the first semiconductor transformer module 10_1, and the third semiconductor transformer module 10_3 is disposed subsequent to the second semiconductor transformer module 10_2. In this way, the n^{th} semiconductor transformer module 10_n is disposed subsequent to the (n-1)^{th} semiconductor transformer module 10_n-1.

In this case, the semiconductor transformer modules 10_1, 10_2, ..., and 10_n may have a stack structure in which the semiconductor transformer modules 10_1, 10_2, ..., and 10_n are sequentially stacked in a vertical direction or may have a planar array structure in which the semiconductor transformer modules 10_1, 10_2, ..., and 10_n are sequentially disposed in a lateral direction. Of course, the first input terminal of the first semiconductor transformer module 10_1 is connected to the first output terminal of the power source 20, and the second input terminal of the n^{th} semiconductor transformer module 10_n is connected to the second output terminal of the power source 20.

Of course, the contents of the above-described "arrangement structure" may be applied to the second housings 17. That is, the second housings 17 connected in series may have a structure in which the second housings 17 are sequentially disposed. Accordingly, the 2_2 housing is disposed subsequent to the 2_1 housing, the 2_3 housing is disposed subsequent to the 2_2 housing. In this way, the 2_n housing is disposed subsequent to the 2_n-1 housing.

In this case, the second housings 17 may have a stack structure in which the second housings 17 are sequentially stacked in the vertical direction or may have a planar array structure in which the second housings 17 are sequentially disposed in a plane direction. Of course, the first input terminal of the first high-voltage portion is connected to the first output terminal of the power source 20, and the second input terminal of the n^{th} high-voltage portion is connected to the second output terminal of the power source 20. Of course, one of the above-described second to n^{th} spaces are provided between the second housings 17, and the corresponding spaces may be insulated from each other.

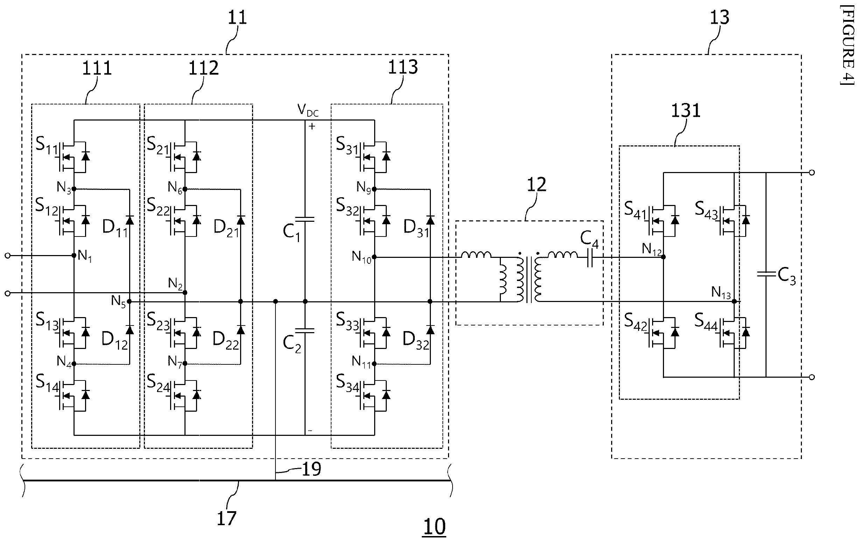

FIG. 4 illustrates an example of a circuit diagram (for example, a, topology) of each semiconductor transformer module 10_1, 10_2, ..., or 10_n.

Next, with regard to the "ground connection structure," in the semiconductor transformer modules 10_1, 10_2, ..., and 10_n, a ground line 19 of each second housing 17 is connected to one of lines provided in a circuit of the high-voltage portion 11 in the corresponding second housing 17. That is, one end of the ground line 19 is connected to the second housing 17, and the other end of the ground line 19 is connected to one of the lines provided in the circuit of the high-voltage portion 11 in the corresponding second housing 17.

Hereinafter, the ground line 19 of the 2_1 housing will be referred to as a "first ground line", and the ground line 19 of the 2_2 housing will be referred to as a "second ground line." In this way, the ground line 19 of the 2_n-1 housing will be referred to as an "(n-1)^{th} ground line," and the ground line 19 of the 2_n housing will be referred to as an "n^{th} ground line."

In addition, a portion to which the other end of the first ground line is connected among circuit lines of the first high-voltage portion will be referred to as a "first connection portion," and a portion to which the other end of the second ground line is connected among circuit lines of the second high-voltage portion will be referred to as a "second connection portion." In this way, a portion to which the other end of the n^{th} ground line is connected among circuit lines of the n^{th} high-voltage portion is referred to as an "n^{th} connection portion."

As an example, as shown in FIG. 4, the ground line 19 may be connected between DC link capacitors C₁ and C₂ of the high-voltage portion 11 in the corresponding second housing 17. That is, the first ground line may be connected between the DC link capacitors C₁ and C₂ of the first high-voltage portion, the second ground line may be connected between the DC link capacitors C₁ and C₂ of the second high-voltage portion, and in this way, the n^{th} ground line may be connected to a node N₅ between the DC link capacitors C₁ and C₂ of the n^{th} high-voltage portion. However, the present invention is not limited thereto, and the ground line 19 may also be connected to any circuit line in the high-voltage portion 11.

For example, the ground line 19 may be a first electrode of a switch element S₁₁ (uppermost portion in FIG. 4, hereinafter referred to as an "uppermost line"), a second electrode of a switch element S₁₄ (lowermost portion in FIG. hereinafter referred to as a "lowermost line"), or a node N₁, N₂, N₃, N₄, N₅, N₆, N₇, N₉, N₁₀, or N₁₁.

In the present invention, since the above-described "ground connection structure" is implemented, a degree of insulation for each space can be reduced as compared to a case in which each ground line 19 is connected to a ground of the housing 30 (hereinafter referred to as a "comparative example"). Thus, since power is distributed to each high-voltage portion 11 according to the above-described arrangement structure," each of potential differences between two adjacent high-voltage portions 11 can be further reduced as compared to the case of the comparative example, and at the same time, since each ground line 19 is connected to the circuit line of the high-voltage portion 11, an effect of the above-described reduced potential difference also affects each second housing 17 without any change to also reduce a potential difference in each space SP. As a result, a degree of insulation (insulation distance) for each space SP can be reduced as compared to the comparative example, and thus the cost and volume can also be reduced.

### <First embodiment of ground connection structure>

Each ground line 19 may be connected to a line to which a potential with the same potential difference is applied in the corresponding high-voltage portion 11. That is, in each high-voltage portion 11, potential differences between first to n^{th} connection portions and the same reference point (that is, the same position point of a line inside the high-voltage portion) may each have the same value. Of course, potential differences between the first to n^{th} connection portions and the second output terminal of the power source 20 may have different values.

As an example, as shown in FIG. 4, the first to n^{th} connection portions may each be connected to the node N₅ of the high-voltage portion 11 or may be connected to a point having the same potential as the node N₅ in the high-voltage portion 11. That is, the first to n^{th} connection portions are each connected to a position in the high-voltage portion 11 to which a potential with the same potential difference with respect to the same reference point is applied.

In this way, when the first to n^{th} connection portions have the same voltage in each high-voltage portion 11, the second to n^{th} spaces SP₂ to Sₙ have a potential difference in the same range. That is, a potential difference in the second space SP₂ which is a potential difference between the 2_1 housing and the 2_2 housing, a potential difference in the third space SP₃ which is a potential difference between the 2_2 housing and the 2_3 housing, and a potential difference in the n^{th} space SPₙ which is a potential difference between the 2_n-1 housing and the 2_n housing each also have a value in the same range.

This is because while power of the power source 20 is distributed to each high-voltage portion 11, potential differences between two adjacent high-voltage portions 11 all have a value in the same range, and in each high-voltage portion 11, potential differences between the first to n^{th} connection portions and the same reference point in each high-voltage portion 11 also has a value in the same range.

In this way, since the second to n^{th} spaces SP₂ to SPₙ each have the same potential difference, a degree of insulation provided in each of the second to n^{th} spaces SP₂ to SPₙ may also be provided to be the same.

As an example, when n is 10 and a power of 10 kV is supplied from the power source 20, a power of 1 kV is equally distributed and supplied to each of the first to n^{th} high-voltage portions. In this case, when potential differences between the first to n^{th} connection portions and the same reference point in each high-voltage portion 11 is the same, the second to n^{th} spaces SP₂ to SPₙ may each have a potential difference of 1 kV. That is, a potential difference in the second space SP₂ which is a potential difference between the 2_1 housing and the 2_2 housing, a potential difference in the third space SP₃ which is a potential difference between the 2_2 housing and the 2_3 housing, and a potential difference in the n^{th} space SPₙ which is a potential difference between the 2_n-1 housing and the 2_n housing each have a value of 1 kV.

Accordingly, the second space SP₂ only needs to have a degree of insulation corresponding to 1 kV, the third space SP₃ only needs to have a degree of insulation corresponding to 1 kV, and similarly, the n^{th} space SPₙ only needs to have a degree of insulation corresponding to 1 kV. As a result, the second to n^{th} spaces SP₂ to SPₙ may be insulated from each other with the same insulation distance.

### <Second embodiment of ground connection structure>

In addition, the ground line 19 may be connected such that at least one of the second to n^{th} spaces SP₂ to SPₙ has a lower degree of insulation than another space. Hereinafter, such a space will be referred to as a "low-insulation space," and two adjacent housings 17 forming the low-insulation space will be referred to as a "first low-insulation housing" and a "second low-insulation housing," respectively. The high-voltage portion 11 in the first low-insulation housing will be referred to as a "first low-insulation high-voltage portion," and the high-voltage portion 11 in the second low-insulation housing will be referred to as a "second low-insulation high-voltage portion." In this case, the first low-insulation housing corresponds to a housing closer to the first output terminal of the power source 20 (that is, a housing positioned at a relatively upper side in FIGS. 1 and 2), and the second low-insulation housing corresponds to a housing closer to the second output terminal of the power source 20 (that is, a housing positioned at a relatively lower side in FIGS. 1 and 2).

In order to implement such a low-insulation space, the other end of each of the ground lines 19 of the first and second low-insulation housings is connected such that a potential difference between the first low-insulation housing and the second low-insulation housing is lower than that in the first embodiment described above, and thus a degree of insulation becomes lower and an insulation distance becomes shorter.

To this end, the other end of the ground line 19 of the first low-insulation housing should be connected to a connection portion to which a potential with a potential difference lower than that of the other end of the ground line 19 of the second low-insulation housing is applied. That is, a potential difference between the connection portion of the first low-insulation high-voltage portion and the same reference point in the first and second low-insulation high-voltage portions should be lower than a potential difference between the connection portion of the second low-insulation high-voltage portion and the same reference point.

When the third space SP₃ is a low-insulation space, the first low-insulation housing is the 2_2 housing, and the second low-insulation housing is the 2_3 housing. In this case, a potential difference between the second connection portion (the other end of a second ground line) and the same reference point in the second high-voltage portion 11 is preferably lower than a potential difference between the third connection portion (the other end of a third ground line) and the same reference point in the third high-voltage portion 11. For example, the second connection portion may be connected to a point (for example, the above-described lowermost line) with a potential difference lower than a potential difference between the node N₅ and the same reference point in the second high-voltage portion 11, and the third connection portion may be connected to a point (for example, the above-described uppermost line) with a potential difference higher than the potential difference between the node N₅ and the same reference point in the third high-voltage portion 11.

However, the ground line 19 related to at least one space among the remaining spaces other than the low-insulation space may be connected according to the first embodiment described above.

### <Third embodiment of ground connection structure>

Meanwhile, the ground line 19 may be connected such that at least one of the second to n^{th} spaces SP₂ to SPₙ has a higher degree of insulation than at least another space. Hereinafter, such a space will be referred to as a "high-insulation space," and two adjacent housings 17 forming the high-insulation space will be referred to as a "first high-insulation housing" and a "second high-insulation housing," respectively. The high-voltage portion 11 in the first high-insulation housing will be referred to as a "first high-insulation high-voltage portion," and the high-voltage portion 11 in the second high-insulation housing will be referred to as a "second high-insulation high-voltage portion." In this case, the first high-insulation housing corresponds to a housing closer to the first output terminal of the power source 20 (that is, a housing positioned at a relatively upper side in FIGS. 1 and 2), and the second high-insulation housing corresponds to a housing closer to the second output terminal of the power source 20 (that is, a housing positioned at a relatively lower side in FIGS. 1 and 2).

In order to implement such a high-insulation space, the other end of each of the ground lines 19 of the first and second high-insulation housings is connected such that a potential difference between the first high-insulation housing and the second high-insulation housing is higher than that in the first embodiment described above, and thus a degree of insulation becomes higher and an insulation distance becomes longer.

To this end, the other end of the ground line 19 of the first high-insulation housing should be connected to a connection portion to which a potential with a potential difference higher than that of the other end of the ground line 19 of the second high-insulation housing is applied. That is, a potential difference between the connection portion of the first high-insulation high-voltage portion and the same reference point in the first and second high-insulation high-voltage portions should be higher than a potential difference between the connection portion of the second high-insulation high-voltage portion and the same reference point.

When the third space SP3 is a high-insulation space, the first high-insulation housing is the 2_2 housing, and the second high-insulation housing is the 2_3 housing. In this case, a potential difference between the second connection portion (the other end of the second ground line) and the same reference point in the second high-voltage portion 11 is preferably higher than a potential difference between the third connection portion (the other end of the third ground line) and the same reference point in the third high-voltage portion 11. For example, the second connection portion may be connected to a point (for example, the above-described uppermost line) with a potential difference higher than a potential difference between the node N₅ and the same reference point in the second high-voltage portion 11, and the third connection portion may be connected to a point (for example, the above-described lowermost line) with a potential difference lower than the potential difference between the node N₅ and the same reference point in the third high-voltage portion 11.

However, the ground line 19 related to at least one space among the remaining spaces other than the high-insulation space may be connected according to the first embodiment described above.

Of course, the first to third embodiments described above may be combined with each other. For example, at least one low-insulation space according to the second embodiment may be included, at least one high-insulation space according to the third embodiment may be included, and the remaining spaces may have the same degree of insulation according to the first embodiment.

Hereinafter, the detailed connection and operation of each component of a circuit diagram of the semiconductor transformer module 10 will be described.

Referring to FIG. 4, the semiconductor transformer module 10 includes the high-voltage portion 11, the transformation portion 12, and the low-voltage portion 13.

In the semiconductor transformer module 10, the high-voltage portion 11 processes input high-voltage power, actively controls low-frequency AC power output from the power source 20, converts the low-frequency AC power to DC power, and converts the converted DC power into high-frequency AC power.

The high-voltage portion 11 includes two full bridge legs 111 and 112 that have three levels and are connected in series with each other and a half bridge 113 having three levels and includes DC link capacitors C₁ and C₂ provided between a second full bridge leg 112 and the half bridge 113. In this case, the DC link capacitors C₁ and C₂ are connected in series. That is, the other end of the first DC link capacitor C₁ and one end of the second DC link capacitor C₂ are connected, and a node N₂ is formed therebetween.

A first output terminal of the second full bridge leg 112 is connected to one end of the first DC link capacitor C₁ and a first input terminal of the half bridge 113, and a second output terminal of the second full bridge leg 112 is connected to the other end of the second DC link capacitor C₂ and a second input terminal of the half bridge 113.

In addition, first input terminals of the first and second full bridge legs 111 and 112, to which any one power line is connected, are connected to a node N₁, and second input terminals of the first and second full bridge legs 111 and 112, to which another power line is connected, are connected to a node N₂. That is, the node N₁ is connected to one of the lines L₁, L₂, ..., Ln, and Lₙ₊₁, and the node N₂ is connected to another one of the lines L₁, L₂, ..., Ln, and Lₙ₊₁. As an example, when the semiconductor transformer module 10 is a first module in the semiconductor transformer 1, the node N₁ is connected to the line L₁, and the node N₂ is connected to the line L₂.

In addition, one end and the other end of a DC link capacitor C₃ are connected to the first and second output terminals of the first and second full bridge legs 111 and 112, respectively.

The first full bridge leg 111 includes four switch elements S₁₁, S₁₂, S₁₃, and S₁₄ and two diodes D₁₁ and D₁₂. Likewise, the second full bridge 112 includes four switch elements S₂₁, S₂₂, S₂₃, and S₂₄ and two diodes D₂₁ and D₂₂.

Whether to turn on or off the switch elements S₁₁, S₁₂, S₁₃, and S₁₄, S₂₁, S₂₂, S₂₃, and S₂₄ of the first and second full bridge legs 111 and 112 is determined according to a control signal of the controller (not shown). For example, the switch elements S₁₁, S₁₂, S₁₃, S₁₄, S₂₁, S₂₂, S₂₃, and S₂₄ may be power switch elements such as insulated gate bipolar transistors (IGBTs), metal oxide silicon field effect transistors (MOSFETs), or gate turn-off thyristors (GTOs).

Each of the switch elements S₁₁, S₁₂, S₁₃, S₁₄, S₂₁, S₂₂, S₂₃, and S₂₄ includes three electrodes. In this case, one of the three electrodes is a gate G, another one (for example, one end) is a first electrode, and still another one (that is, the other end) is a second electrode. For example, when the switch elements S₁₁, S₁₂, S₁₃, S₁₄, S₂₁, S₂₂, S₂₃, and S₂₄ are the MOSFETs, one of the first electrode and the second electrode may be a source S, and the other one may be a drain D. In each of the switch elements S₁₁, S₁₂, S₁₃, S₁₄, S₂₁, S₂₂, S₂₃, and S₂₄, a control signal line of the controller (not shown) may be connected to the gate G, and an additional diode may be connected between the first electrode and the second electrode.

In the first full bridge leg 111, the switch element S₁₁, S₁₂, S₁₃, and S₁₄ are connected in series. That is, the other end of the switch element S₁₁ and one end of the switch element S₁₂ are connected to form the node N₃, the other end of the switch element S₁₂ and one end of the switch element S₁₃ are connected to form the node N₁, and the other end of the switch element S₁₃ and one end of the switch element S₁₄ are connected to form the node N₄. In this case, one end of the switch element S₁₁ is connected to one end of the first DC link capacitor C₁, and the other end of the switch element S₁₄ is connected to the other end of the second DC link capacitor C₂.

In addition, in the first full bridge leg 111, the diodes D₁₁ and D₁₂ are also connected in series. That is, the other end of the diode D₁₁ and one end of the diode D₁₂ are connected to form the node N₅. In this case, one end of the diode D₁₁ is connected to the node N₃, and the other end of the diode D₁₂ is connected to the node N₄.

Likewise, in the second full bridge leg 112, the switch elements S₂₁, S₂₂, S₂₃, and S₂₄ are connected in series. That is, the other end of the switch element S₂₁ and one end of the switch element S₂₂ are connected to form the node N₆, the other end of the switch element S₂₂ and one end of the switch element S₂₃ are connected to form the node N₂, and the other end of the switch element S₂₃ and one end of the switch element S₂₄ are connected to form the node N₇. In this case, one end of the switch element S₂₁ is connected to one end of the first DC link capacitor C₁, and the other end of the switch element S₂₄ is connected to one end of a capacitor C₄.

In addition, in the second full bridge 112, the diodes D₂₁ and D₂₂ are also connected in series. That is, the other end of the diose D₂₁ and one end of the diode D₂₂ are connected to each other and connected to the node N₅. In this case, one end of the diode D₁₁ is connected to the node N₆, and the other end of the diode D₂₂ is connected to the node N₇.

The first and second full bridge legs 111 and 112 form a full bridge and operate as an active front end (AFE) converter and actively control low-frequency AC power output from the power source 20 into DC power using a switch element capable of controlling tum-on/off. The AFE converter has advantages of controlling a voltage of the DC link capacitors C₁ and C₂ (hereinafter referred to as "link voltage"), maintaining a constant DC link voltage, controlling a power factor of an input, and removing harmonic waves included in an input current.

The first and second full bridge legs 111 and 112 each have three levels. That is, in the first full bridge leg 111, a first level corresponds to a state in which the switch elements S₁₁ and S₁₂ are turned on and the switch elements S₁₃ and S₁₄ are turned off, a second level corresponds to a state in which the switch elements S₁₁ and S₁₂ are turned off and the switch elements S₁₃ and S₁₄ are turned on, and a third level corresponds to a state in which the switch elements S₁₁ and S₁₄ are turned on. Likewise, in the second full bridge 112, a first level corresponds to a state in which the switch elements S₂₁ and S₂₂ are turned on and the switch elements S₂₃ and S₂₄ are turned off, a second level corresponds to a state in which the switch elements S₂₁ and S₂₂ are turned off and the switch elements S₂₃ and S₂₄ are turned on, and a third level corresponds to a state in which the switch elements S₂₁ and S₂₄ are turned on. Accordingly, a total of five levels may be output by the first and second full bridge legs 111 and 112. That is, when a voltage between one end of the first DC link capacitor C₁ and the other end of the second DC link capacitor C₂ is assumed to be V_{DC}, according to a combination operation of the first and second full bridge legs 111 and 112 each having three levels, a voltage between the node N₁ and the node N₂ may exhibit a total of five levels of V_{DC}, V_{DC}/2, 0, -V_{DC}/2, and -V_{DC}.

The half bridge 113 converts DC power converted in the first and second full bridge legs 111 and 112 into high-frequency AC power. In this case, the half bridge 113 includes four switch elements S₃₁, S₃₂, S₃₃, and S₃₄ and two diodes D₃₁ and D₃₂. The transformation portion 12 includes a primary side and a secondary side. The full bridge 131 includes four switch elements S₄₁, S₄₂, S₄₃, and S₄₄.

Each of the switch elements S₃₁, S₃₂, S₃₃, S₃₄, S₄₁, S₄₂, S₄₃, and S₄₄ includes three electrodes. In this case, one of the three electrodes is a gate G, another one (for example, one end) is a first electrode, and still another one (that is, the other end) is a second electrode. For example, when the switch elements S₃₁, S₃₂, S₃₃, S₃₄, S₄₁, S₄₂, S₄₃, and S₄₄ are MOSFETs, one of the first electrode and the second electrode may be a source S, and the other one may be a drain D. In each of the switch elements S₃₁, S₃₂, S₃₃, S₃₄, S₄₁, S₄₂, S₄₃, and S₄₄, the control signal line of the controller (not shown) may be connected to the gate G, and an additional diode may be connected between the first electrode and the second electrode.

In the half bridge 113, the switch element S31, S₃₁, S₃₂, S₃₃, and S₃₄ are connected in series. That is, the other end of the switch element S₃₁ and one end of the switch element S₃₂ are connected to form the node N₉, the other end of the switch element S₃₂ and one end of the switch element S₃₃ are connected to form the node N₁₀, and the other end of the switch element S₃₃ and one end of the switch element S₃₄ are connected to form the node N₁₁. In this case, one end of the switch element S₃₁ may be connected to one end of the first DC link capacitor C₁ to serve as a first input terminal of a dual-active-bridge (DAB) converter 200, and the other end of the switch element S₃₄ may be connected to the other end of the second DC link capacitor C₂ to serve as a second input terminal of an AFE converter 100.

In addition, in the half bridge 113, the diodes D₃₁ and D₃₂ are also connected in series. That is, the other end of the diode D₃₁ and one end of the diode D₃₂ are connected to each other and connected to the node N₅. In this case, one end of the diode D₃₁ is connected to the node N₉, and the other end of the diode D₃₂ is connected to the node N₁₁.

The half bridge 113 has three levels. That is, in the half bridge 113, a first level corresponds to a state in which the switch elements S₃₁ and S₃₂ are turned on and the switch elements S₃₃ and S₃₄ are turned off, a second level corresponds to a state in which the switch elements S₃₂ and S₃₃ are turned on and the switch elements S₃₁ and S₃₄ are turned off, and a third level corresponds to a state in which the switch elements S₃₁ and S₃₂ are turned off and the switch elements S₃₃ and S₃₄ are turned on. In this case, as a voltage between a first output terminal (N₁₀) and a second output terminal (Ns) of the half bridge 113, V_{DC}/2 may be applied at the first level, 0 V may be applied at the second level, and -V_{DC}/2 may be applied at the third level. As an example, according to a control signal of the controller, a first process of sequentially changing from the first level to the third level, and then, a second process of sequentially changing from the third level to the first level may be repeatedly performed to perform an operation of converting DC power converted in the first and second full bridge legs 111 and 112 into high-frequency AC power.

In the semiconductor transformer module 10, the transformation portion 12 transforms high-frequency AC power converted in the half bridge 113 into high-frequency low voltage AC power. In this case, the first output terminal of the half bridge 113 connected to a first input terminal of the transformation portion 12 is the node N₁₀, and the second output terminal of the half bridge 113 connected to a second input terminal of the transformation portion 12 is the node N₅.

The primary side and the secondary side of the transformation portion 12 may each include coils having various windings. In this case, it may be preferable that a number of turns of coils of the primary side be greater than a number of coil turns of coils of the secondary side. That is, a converted high-frequency AC power input to the primary side is transformed into a high-frequency low-voltage AC power according to a relationship between the number of turns in the primary side and the secondary side.

In this case, a first input terminal of the primary side serves as a first input terminal of the transformation portion 12 and is connected to the node N₁₀ which is a first output terminal of the half bridge 113. A second input terminal of the primary side serves as a second input terminal of the transformation portion 12 and is connected to the node N₅ which is a second output terminal of the half bridge 113. In addition, an active element (such as an inductor) or a passive element (such as a resistor) may be additionally connected to the primary side.

A first output terminal of the secondary side serves as a first output terminal of the transformation portion 12 and is connected to the node N₁₁ which is a first input terminal of the third full bridge 131. A second output terminal of the secondary side serves as a second output terminal of the transformation portion 12 and is connected to the node N₁₂ which is a second input terminal of the third full bridge 131. In addition, an active element (such as an inductor) or a passive element (such as a resistor) may be additionally connected to the primary side. In particular, the capacitor C₄ for a DC blocking function (that is, a function of removing a DC component from transformed low-voltage AC power) may be additionally connected to the first or second output terminal of the secondary side.

In the semiconductor transformer module 10, the low-voltage portion 13 converts a high-frequency low-voltage AC power converted in the transformation portion 12 into low-voltage DC power. The low-voltage portion 13 includes the third full bridge 131 having two levels and the DC link capacitor C₃ connected to the third full bridge 131.

The third full bridge 131 includes four switch elements S₄₁, S₄₂, S₄₃, and S₄₄. Whether to turn on or off the switch elements S₄₁, S₄₂, S₄₃, and S₄₄ of the third full bridge 131 is determined according to a control signal of the controller (not shown). For example, the switch elements S₄₁, S₄₂, S₄₃, and S₄₄ may be power switch elements such as IGBTs, MOSFETs, or GTOs.

Each of the switch elements S₄₁, S₄₂, S₄₃, and S₄₄ includes three electrodes. In this case, one of the three electrodes is a gate G, another one (for example, one end) is a first electrode, and still another one (that is, the other end) is a second electrode. For example, when the switch elements S₄₁, S₄₂, S₄₃, and S₄₄) are the MOSFETs, one of the first and second electrodes may be a source S, and the other may be a drain D. In each of the switch elements S₄₁, S₄₂, S₄₃, and S₄₄), the control signal line of the controller (not shown) may be connected to the gate G, and an additional diode may be connected between the first electrode and the second electrode.

The switch elements S₄₁ and S₄₂ connected to each other in series form one full bridge leg, and the switch elements S₄₃ and S₄₄ connected to each other in series form another full bridge leg. That is, the other end of the switch element S₄₁ and one end of the switch element S₄₂ are connected to form the node N₁₁, and the other end of the switch element S₄₃ and one end of the switch element S₄₄ are connected to form the node N₁₂. In this case, one end of the switch element S₄₁ and one end of the switch element S₄₃ may be connected to one end of the DC link capacitor C₃ to serve as a first output terminal of the third full bridge 131, and the other ends of the switch elements S₄₂ and S₄₄ may be connected to the other end of the DC link capacitor C₃ to serve as a second output terminal of the third full bridge 131. In addition, one end of the DC link capacitor C₃ may serve as a first output terminal of the semiconductor transformer module 10 to be connected to a first terminal of the load R_{L}, and the other end of the DC link capacitor C₃ may serve as a second output terminal of the semiconductor transformer module 10 to be connected to a second terminal of the load R_{L}.

The third full bridge 131 has two levels. That is, in the third full bridge 131, a first level corresponds to a state in which the switch elements S₄₁ and S₄₄ are turned on and the switch elements S₄₂ and S₄₃ are turned off, and a second level corresponds to a state in which the switch elements S₄₁ and S₄₄ are turned off and the switch elements S₄₂ and S₄₃ are turned on. Processes of the first level and second level may be repeatedly performed to perform a third operation of converting a high-frequency and low-voltage AC power converted in the transformation portion 12 into DC power, and according to the third operation, the DC power applied to the DC link capacitor C₃ may be transmitted to the load R_{L}.

Meanwhile, the half bridge 113, transformation portion 12, and third full bridge 131 operate as one DC-DC converter. That is, a first operation of converting DC power converted in the first and second full bridge legs 111 and 112 into high-frequency AC power, a second operation of transforming the converted high-frequency AC power into high-frequency and low-voltage AC power, and a third operation of converting the high-frequency and low-voltage AC power into low-voltage DC power may be performed. The DC-DC converter may correspond to a DAB converter which is one of isolated bidirectional DC-DC converters. Unlike bidirectional resonant converters such as capacitor-inductor-inductor-capacitor (CLLC) converters, the DC-DC converter has an advantage in that a direction change of a load current is smooth, and a power direction is easily controlled by a phase shift.

In the semiconductor transformer module 10 of FIG. 4, the ground line 19 is connected to one of lines provided in a circuit of the high-voltage portion 11. That is, one end of the ground line 19 is connected to the second housing 17 surrounding the high-voltage portion 11, and the other end (that is, a connection portion) of the ground line 19 is connected to one of the lines provided in the circuit of the high-voltage portion 11.

In this case, the connection portion of the ground line 19 may be connected one among the lines of the high-voltage portion 11 of the semiconductor transformer module 10 of FIG. 4 according to any one of the first to third embodiments of the above-described ground connection structure. Since connection according to the first to third embodiments of the ground connection structure has already been described in detail, the connection will be omitted below.

The semiconductor transformer 1 described above may be an example of a modular high-voltage power device. In this case, the modular high-voltage power device is a device that processes high-voltage power in power transmission, power distribution, or electrical distribution in a system and includes a plurality of modules connected in series to receive distributed voltages of input power. In this case, each module may include a module housing made of a conductive material for the corresponding module a potentiodynamic device in the corresponding module, and the potentiodynamic device that electrically connects specific parts of the corresponding module. In one example, the module housing may surround at least a portion of the potentiodynamic device. In this case, an example of the plurality of modules may be the semiconductor transformer module 10 described above, and an example of the module housing may be the first housing 30 described above or the second housing 17 described above. An example of the potentiodynamic device may be the high-voltage portion 11 described above.

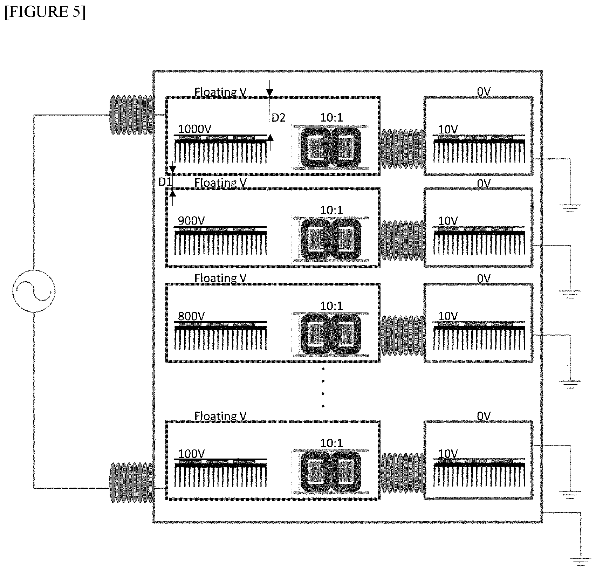

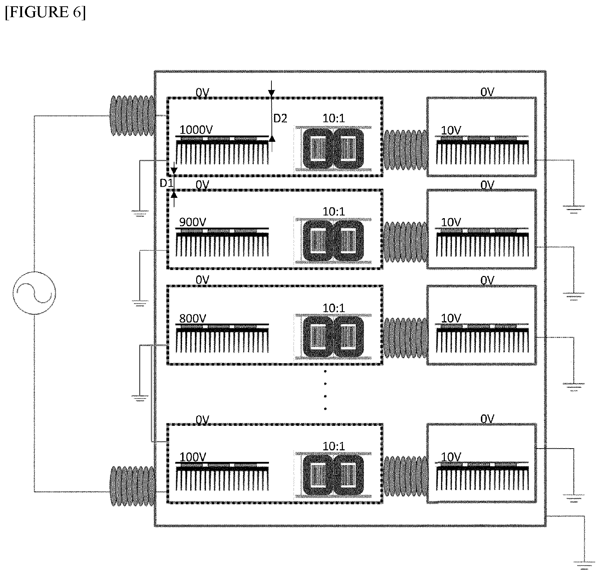

FIGS. 5 and 6 illustrate examples of a potential applied to semiconductor transformers according to first and second comparative examples.

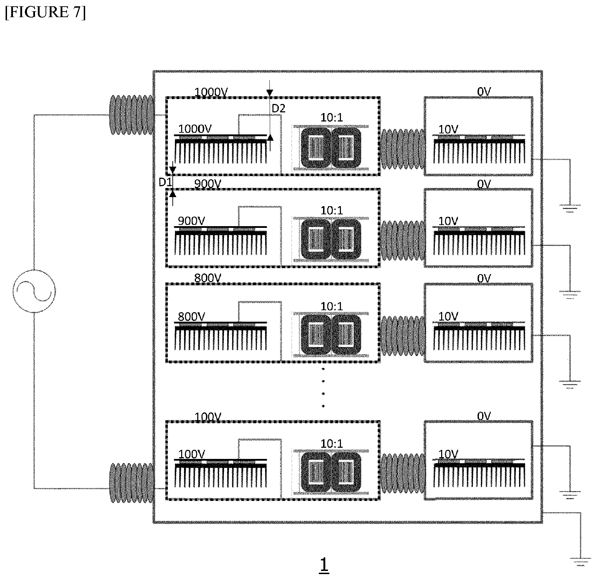

FIG. 7 illustrates an example of a potential applied to the semiconductor transformer 1 according to one embodiment of the present invention. In FIGS. 5 to 7, most of the reference numerals for respective components are omitted, and FIG. 1 may be referred for the corresponding reference numerals.

Meanwhile, referring to FIGS. 5 and 6, there are cases in which the ground line 19 is not provided in the semiconductor transformer 1 according to one embodiment of the present invention. That is, FIG. 5 corresponds to the first comparative example in which the ground line 19 is not provided in the semiconductor transformer 1 according to one embodiment of the present invention, and no external ground is connected to the second housing 17. The first comparative example corresponds to a case in which a potential of the second housing 17 of the high-voltage portion 11 is not fixed at all. In addition, FIG. 6 corresponds to the second comparative example in which the ground line 19 is not provided in the semiconductor transformer 1 according to one embodiment of the present invention, but an external ground is separately connected to the second housing 17. The second comparative example corresponds to a case in which a potential of the second housing 17 of the high-voltage portion 11 is fixed as a ground potential.

In FIGS. 5 to 7, when n is 10 and a power of 1 kV is supplied from the power source 20, a power of 100 V is equally distributed to each of the first to n^{th} high-voltage portions. In this case, D₁ denotes an insulation distance between two adjacent second housings 17, and D₂ denotes an insulation distance between one second housing 17 and the high-voltage portion 11 therein.

Referring to FIG. 5, in the first comparative example, since a potential of each second housing 17 floats, a potential difference between two adjacent second housings 17 also floats. In this case, since a floating range is 0 V to 1,000 V, an insulation design of very long D₁ based on a maximum of 1,000 V should be performed. In addition, since a potential of each second housing 17 floats, a potential difference between the second housing 17 and the high-voltage portion 11 also floats. In this case, since a floating range is 0 V to 1,000 V, an insulation design of very long D₂ based on a maximum of 1,000 V should be performed.

Referring to FIG. 6, in the second comparative example, since a potential of each second housing 17 is 0 V, an insulation design of D₁ shorter than that of the first comparative example is possible. In this case, since a potential of each second housing 17 is 0 V, an insulation design of D₂ based on a range of 100 V to 1,000 V should be performed for each module. In particular, in a structure using modules with identical specifications, an insulation design of D₂ based on a maximum value of 1,000 V should be performed, and thus an unnecessary excessive insulation design (waste element) occurs in the case of a lower module.

On the other hand, referring to FIG. 7, in the present invention, since a potential difference between the second housings 17 may be fixed as 100 V, insulation designs of D₁, which are all the same and are based on a very low voltage of 100 V, only need to be performed. In addition, for a potential difference between the second housing 17 and the high-voltage portion 11, an insulation design of very short D₂ based on a range of 0 V to 100 V only needs to be performed. That is, in the first and second comparative examples, a wasteful insulation design based on a maximum of 1,000V should be performed, but according to the present invention, an economical insulation design based on 100 V is possible.

The present invention configured as described above can be implemented to reduce a voltage difference between housings of high-voltage portions in a modular high-voltage power device including a plurality of semiconductor transformer modules, and thus a degree of insulation between the housings can be reduced, thereby obtaining an advantage capable of reducing manufacturing costs and volume. In addition, according to the present invention, as configured as shown in FIG. 4, the number of switch elements in a semiconductor transformer module can be reduced, thereby further reducing manufacturing costs.

While specific embodiments have been described in the detailed description of the present invention, various modifications may be made without departing from the scope of the present invention. Therefore, the scope of the present invention is defined not by the described embodiment but by the appended claims and encompasses equivalents that fall within the scope of the appended claims.

### [Industrial Applicability]

The present invention relates to a semiconductor transformer and a modular high-voltage power device. There can be provided a semiconductor transformer and a modular high-voltage power device which are implemented to reduce a voltage difference between housings of high-voltage portions in a plurality of semiconductor transformer modules, thereby reducing a degree of insulation between the housings. Thus, the present invention has industrial applicability.

## Claims

1. A semiconductor transformer comprising a plurality of semiconductor transformer modules configured to convert power,
wherein each of the semiconductor transformer modules includes:
a high-voltage portion configured to convert low-frequency AC power into high-frequency AC power;
a transformation portion configured to transform the converted high-frequency AC power into high-frequency and low-voltage AC power; and
a low-voltage portion configured to convert the transformed high-frequency and low-voltage AC power into low-voltage DC power,
wherein the high-voltage portion is provided in a housing made of a conductive material, and
a ground line of the housing is connected to one of circuit lines of the high-voltage portion.

2. The semiconductor transformer of claim 1, wherein the high-voltage portions of the plurality of semiconductor transformer modules are connected in series to each other in terms of power.

3. The semiconductor transformer of claim 2, wherein the housings of the plurality of semiconductor transformer modules are disposed in a stack structure or a planar array structure according to a series order, and
insulating structures are implemented between the housings.

4. The semiconductor transformer of claim 3, wherein the ground line of each housing is connected to a circuit line to which a potential having the same potential difference with respect to the same reference point in each high-voltage portion is applied.

5. The semiconductor transformer of claim 4, wherein the insulating structures between the housings have an insulation distance in the same range.

6. The semiconductor transformer of claim 3, wherein, in at least one of a plurality of housing pairs consisting of two adjacent housings, among two ground lines in a corresponding housing pair, a first ground line is connected to a circuit line to which a potential having a high potential difference with respect to the same reference point in each high-voltage portion is applied as compared to the other second ground line.

7. The semiconductor transformer of claim 6, wherein the at least one housing pair has a shorter insulation distance than at least one of the other housing pairs.

8. The semiconductor transformer of claim 6, wherein the at least one housing pair has a longer insulation distance than at least one of the other housing pairs.

9. The semiconductor transformer of claim 3, wherein, in at least one housing pair among a plurality of housing pairs consisting of two adjacent housings, ground lines are connected to a circuit line to which a potential having the same potential difference with respect to the same reference point in each high-voltage portion is applied, and
in at least another housing pair among the plurality of housing pairs, among two ground lines in a corresponding housing pair, a first ground line is connected to a circuit line to which a potential having a high potential difference with respect to the same reference point in each high-voltage portion is applied as compared to the other second ground line.

10. The semiconductor transformer of claim 1, wherein the high-voltage portions of the plurality of semiconductor transformer modules are implemented to have identical specifications so as to distribute the same power.

11. A modular high-voltage power device comprising a plurality of modules which are connected in series and to which voltages of input power are distributed,
wherein each of the modules includes:
a potentiodynamic device configured to electrically connect a specific part of the module; and
a module housing made of a conductive material,
wherein a ground line of the module housing is connected to one of circuit lines of the potentiodynamic device.

12. The modular high-voltage power device of claim 11, wherein each of the modules is a semiconductor transformer module configured to convert power and includes a high-voltage portion configured to convert low-frequency AC power into high-frequency AC power, a transformation portion configured to transform the converted high-frequency AC power into high-frequency and low-voltage AC power, and a low-voltage portion configured to convert the transformed high-frequency and low-voltage AC power into low-voltage DC power,
wherein the high-voltage portion is provided in a housing made of a conductive material, and
a ground line of the housing is connected to one of circuit lines of the high-voltage portion.

13. The modular high-voltage power device of claim 12, wherein the high-voltage portions of the plurality of semiconductor transformer modules are connected in series to each other in terms of power.

14. The modular high-voltage power device of claim 13, wherein the housings of the plurality of semiconductor transformer modules are disposed in a stack structure or a planar array structure according to a series order, and
insulating structures are implemented between the housings.

15. The modular high-voltage power device of claim 14, wherein the ground line of each housing is connected to a circuit line to which a potential having the same potential difference with respect to the same reference point in each high-voltage portion is applied.

16. The modular high-voltage power device of claim 15, wherein the insulating structures between the housings have an insulation distance in the same range.

17. The modular high-voltage power device of claim 14, wherein, in at least one of a plurality of housing pairs consisting of two adjacent housings, among two ground lines in a corresponding housing pair, a first ground line is connected to a circuit line to which a potential having a high potential difference with respect to the same reference point in each high-voltage portion is applied as compared to the other second ground line.

18. The modular high-voltage power device of claim 17, wherein the at least one housing pair has a shorter insulation distance than at least one of the other housing pairs.

19. The modular high-voltage power device of claim 17, wherein the at least one housing pair has a longer insulation distance than at least one of the other housing pairs.

20. The modular high-voltage power device of claim 14, wherein, in at least one housing pair among a plurality of housing pairs consisting of two adj acent housings, ground lines are connected to a circuit line to which a potential having the same potential difference with respect to the same reference point in each high-voltage portion is applied, and
in at least another housing pair among the plurality of housing pairs, among two ground lines in a corresponding housing pair, a first ground line is connected to a circuit line to which a potential having a high potential difference with respect to the same reference point in each high-voltage portion is applied as compared to the other second ground line.
